# EUROPÄISCHE PATENTANMELDUNG

(11) **EP 2 737 998 A1**
(43) Veröffentlichungstag der Anmeldung: **04.06.2014**
(21) Anmeldenummer: 14000659.4
(22) Anmeldetag: 30.11.2010
(51) Int. Cl.: B32B 27/20, B32B 27/34, C08K 3/22, H01L 31/048

(54) **Coextrudatkörper für Solarmodul**

(30) Priorität: 01.12.2009 AT 18982009
(62) Teilanmeldung aus: 10798459.3
(71) Anmelder: ISOVOLTAIC AG, 8403 Lebring (AT)
(72) Erfinder: Mikats, Günther, 7024 Hirm (AT)
(74) Vertreter: Torggler, Paul Norbert

(57) **Zusammenfassung**

Coextrudatkörper (6'), umfassend eine erste Thermoplastschicht (8) mit einem ersten Füllstoff (18), der ein Reflexionsvermögen aufweist, das höher ist als das Reflexionsvermögen des Thermoplasten der ersten Thermoplastschicht (8) und einer zweiten Thermoplastschicht (10), die einen Füllstoff (20) umfasst, der eine höhere Wärmeleitfähigkeit als der Thermoplast der zweiten Thermoplastschicht (10) aufweist, wobei in den beiden Thermoplastschichten (8, 10) der jeweilige Anteil des ersten (18) oder zweiten (20) Füllstoffes vom Anteil des selben Füllstoffs (18, 20) in der jeweils anderen Thermoplastschicht (10, 8) verschieden ist und wobei zumindest eine Thermoplastschicht eine Polyamidschicht ist.

## Beschreibung

Die Erfindung betrifft einen Coextrudatkörper für ein Solarmodul, umfassend wenigstens zwei Thermopfastschichten und Füllstoffe.

Solar- oder Photovoltaikmodule weisen in der Regel eine Solarzelle auf, die zwischen einer Frontabdeckung und einer Rückabdeckung angeordnet ist. Industriell sind Solarzelle auf Siliziumbasis derzeit am bedeutendsten, wenngleich auch andere Materialien immer häufiger Einsatz finden. Die Frontabdeckung besteht in der Regel aus lichtdurchlässigem Glas und ist mit der Solarzelle über einen Haftvermittler aus Ethylen-Vinyl-Acetat (EVA) verbunden. Die Rückabdeckung (oft auch Backsheetfolie genannt) besteht meist aus einer Kunststofffolie auf Fluorpolymerbasis, da Fluorpolymere sehr temperaturbeständig sind. Exemplarisch sei auf Roekens und Beyer, Kunststoffe 5/2007 (S. 92-S. 95) verwiesen, wo eine Rückabdeckung aus einem Dreischichtlaminat Polyvinylfluorid (PVF) - Polyethylenterephthalat (PET) -PVF besteht. Nachteilig beim Stand der Technik gemäß Roekens und Beyer ist der Umstand, dass aufgrund der Fluorhältigkeit der Rückabdeckung deren Recycling nur thermisch, d.h., mittels aufwändiger Verbrennungsverfahren, möglich ist.

Aus der JP 2007-177136 A ist eine Anordnung mit einer Solarzelle und einer Backsheet-Folie bekannt, wobei die Folie Glasfasern, Glimmer, Wollastonit oder Titaniumdioxid beinhalten kann. Nachteilig ist, dass die Eigenschaften dieser Folie über den gesamten Bereich im Wesentlichen unverändert sind und somit keine Anpassung der Eigenschaft in Bezug auf die Nähe zu den Solarzellen erfolgt. Zudem ist dadurch der Materialverbrauch der einzelnen Füllstoffe über die ganze Dicke der Backsheet-Folie sehr groß. In ähnlicher Art und Weise gelten diese Nachteile auch für die US 2008/0264484 A1.

Die EP 2 043 162 A2 beschreibt ein Solarmodul mit einer Frontabdeckung und einer Rückabdeckung aus Kunststoff. Der darin beschriebene Aufbau eignet sich zwar für kleinflächige Anwendungen mit insgesamt niedrigen Leistungen, bei großflächigen Anwendungen, bei denen naturgemäß hohe Temperaturen auftreten, ist der darin gezeigte Aufbau allerdings ungeeignet. Aus der US 6,521,825 B1 sind Solarmodule mit Rückabdeckungen aus mehrschichtigem Kunststoff bekannt.

Aufgabe der vorliegenden Erfindung ist es, einen Kunststoffkörper in der Form eines Coextrudatkörpers für die Rückabdeckung eines Solarmoduls bereitzustellen, wo die beschriebenen Nachteile vermindert sind.

Diese Aufgabe wird durch einen Coextrudatkörper gemäß Anspruch 1 gelöst.

Die Erhöhung des Reflexionsvermögens in der ersten Thermoplastschicht erfüllt zwei Aufgaben. Zum einen trifft mehr Licht auf die Solarzellen, da beispielsweise durch die Solarzelle durchtretendes oder an der Solarzelle vorbeilaufendes Licht auf die Solarzelle zurück reflektiert wird, sodass die Ausbeute an in elektrische Energie umgewandelte elektromagnetische Strahlung erhöht wird. Zum anderen werden die hinter der ersten Thermoplastschicht befindlichen Teile des Solarmoduls von thermischer Energie geschützt.

Durch die Erhöhung der Wärmeleitfähigkeit in der zweiten Thermoplastschicht durch den entsprechenden Füllstoff wird die Langzeittemperaturbeständigkeit (RTI) des Coextrudates und damit des Solarmoduls deutlich erhöht. Damit kann die Leistung insbesondere bei großen Modulen, wo auch hohe Systemspannungen auftreten, erhöht werden.

Durch die Coextrusion ist das Solarmodul einfacher herstellbar.

Durch die nunmehr möglichen größeren Solarmodule und die damit verbundenen größeren Systemspannungen kann vorteilhafterweise vorgesehen sein, dass der zweite Füllstoff zusätzlich die Durchschlagfestigkeit der Thermoplastschicht erhöht. Typischerweise bieten sich elektrische Isolatoren an, die solche Eigenschaften aufweisen. Messungen haben ergeben, dass bei einem Gehalt von 20 Gew.% Füllstoff in der zweiten Thermoplastschicht die Durchschlagsfestigkeit um 12-15% (bezogen auf dieselbe Schicht ohne Füllstoff) verbessert wurde. Um die Langzeittemperaturstabilität noch weiters zu erhöhen, ist es weiterhin günstig, wenn der zweite Füllstoff zusätzlich einen niedrigeren Wärmeausdehnungskoeffizient als der Thermoplast aufweist. Dadurch kommt es zu einer geringeren Ausdehnung des Kunststoffs bei thermischer Belastung. Die dauernde Ausdehnung bei Temperaturanstieg und das anschließende Zusammenziehen beim Abkühlen führen nämlich bei einfachen Kunststoffrückabdeckungen dazu, dass die Kunststoffschicht nach einer bestimmten Betriebsstundenanzahl ausleiert.

Bestimmte Stoffe erfüllen alle Eigenschaften, nämlich eine hohe Wärmeleitfähigkeit, eine hohe Durchschlagfestigkeit und einen niedrigen Wärmeausdehnungskoeffizienten. Insbesondere schichtartige Stoffe wie Glimmer, beispielsweise Muskovit oder in geringem Ausmaß Eisenglimmer, aber auch Wollastonit, Bornitrid, oder faserige Stoffe wie Glasfasern allerdings in geringerem Ausmaß als z.B. Glimmer und natürlich Mischungen aus den genannten Stoffen können eingesetzt werden. Der niedrigere Wärmeausdehnungskoeffizient ergibt eine wesentlich geringere Schwindung, wodurch die eingebetteten Module stabilisiert werden.

Bevorzugt ist die Verwendung von Muskovit mit schichtartigem Aufbau. Generell kann für schichtartige Stoffe vorgesehen sein, dass diese eine Länge und eine Breite von 5 bis 45 µm, vorzugsweise 5 bis 15 µm bei einer Dicke von unter 2 µm, vorzugsweise unter 1 µm aufweisen.

Besonders günstig ist es dabei, wenn der zweite Füllstoff als Compound mit einem Polyolefin vorliegt, d.h. vor der Einbringung in die Thermoplastschicht mit einem Polyolefin als Träger versetzt werden. Durch die anschließende Einbringung in Thermoplasten wird die Wärmeleitfähigkeit und damit die Wärmeabfuhr verbessert und der elektrische Widerstand nicht reduziert. Speziell Glasfasern können so als Füllstoff in Form eines Compounds gut eingesetzt werden. Außerdem sorgt das Polyolefin für eine geringere Wasserdampfdurchlässigkeit der Schicht. Die US 6,521,825 B1 beschäftigt sich ebenfalls mit der Verringerung der Wasserdampfdurchlässigkeit. Dazu wird auf eine Kunststoffschicht ein Silitiumoxid aufgedampft. In weiterer Folge müssen die Schichten der Rückabdeckung laminiert werden, da eine Coextrusion einer Kunststoffschicht mit der aufgedampften Oxidschicht nicht mehr möglich ist. In der vorliegenden Erfindung werden die Füllstoffe in die Schicht eingearbeitet.

Der Anteil an zweitem Füllstoff, bezogen auf die Thermoplastmenge, beträgt vorzugsweise zwischen 5 und 30 Gew.%, vorzugsweise zwischen 10 und 20 Gew.%. Eine Ausführungsvariante sieht in der zweiten Thermoplastschicht vor, dass eine Füllstoffkombination eingebracht ist. Der Füllgrad beträgt dabei in Abhängigkeit von der Dichte der Füllstoffe bis 60 Gew.%. Günstig ist dabei eine Kombination aus Wollastonit und/oder Muskovit mit Glasfasern eingebetet in ein Polyolefin (wie z.B. Polypropylen) als Compound.

Weiters ist in einer besonders bevorzugten Ausführungsvariante vorgesehen, dass der erste Füllstoff Titandioxid TiO₂ umfasst. TiO₂ als erster Füllstoff hat den Vorteil, dass er Licht sehr stark reflektiert und es zu einer über 90%igen Reflexion, vorzugsweise über 99%igen Reflexion bei entsprechender Beimengung kommt. Der Anteil an erstem Füllstoff, bezogen auf die Thermoplastmenge, beträgt vorzugsweise zwischen 5 bis 30 Gew.%.

Ein bevorzugtes Ausführungsbeispiel kann vorsehen, dass nur die erste Thermoplastschicht einen ersten Füllstoff umfasst, der ein Reflexionsvermögen aufweist, das höher ist als das Reflexionsvermögen des Thermoplasten der ersten Thermoplastschicht aufweist. D. h., dass die erste Thermoplastschicht - im Gegensatz zur zweiten Thermoplastschicht - keinen die Wärmeleitfähigkeit wesentlich beeinflussenden Füllstoff aufweist. Es soll aber natürlich nicht ausgeschlossen sein, dass das Thermoplast verschiedene andere (z. B. farbgebende) Füllstoffe beinhaltet.

Im Umkehrschluss sieht ein weiteres bevorzugtes Ausführungsbeispiel vor, dass nur die zweite Thermoplastschicht einen zweiten Füllstoff umfasst, der eine höhere Wärmeleitfähigkeit als der Thermoplast der zweiten Thermoplastschicht aufweist. D. h., dass die zweite Thermoplastschicht - im Gegensatz zur ersten Thermoplastschicht-keinen das Reflexionsvermögen wesentlich beeinflussenden Füllstoff aufweist.

In einer bevorzugten Ausführungsvariante kann vorgesehen sein, dass auf der der Solarzelle abgewandten Seite der zweiten Thermoplastschicht eine weitere Schicht angeordnet ist, die ein niedrigeres Reflexionsvermögen aufweist als die Oberfläche der Frontabdeckung. Bevorzugt ist vorgesehen, dass die weitere Schicht eine dritte Thermoplastschicht ist, welche mit den wenigstens zwei anderen Thermoplastschichten den Coextrudatkörper bildet. Weiters kann vorgesehen sein, dass die weitere Schicht eingefärbt ist und/oder Mattierungsmittel aufweist. Eine Variante der Erfindung kann vorsehen, dass die erste Thermoplastschicht eingefärbt ist. Dies bietet sich z.B. dann an, wenn das Solarmodul als Fassadenelement eingesetzt werden soll. Dazu ist anzumerken, dass die Solarzellen meist nicht vollflächig im Modul angeordnet sind und/oder teilweise lichtdurchlässig ausgebildet sind. Daher ist die Färbung der Rückabdeckung zumindest teilweise auch von der Vorderseite sichtbar.

Die Solarzelle ist meistens in einem Einbettungsmaterial eingebracht. Das Einbettungsmaterial kann gleichzeitig eine Verbindung zwischen Solarzelle und Coextrudatkörper sowie zwischen Solarzelle und Frontabdeckung herstellen, sodass das Einbettungsmaterial als Haftvermittler ausgebildet ist. Der Haftvermittler kann beispielsweise EVA (Ethylenvinylacetat) umfassen. Da die Handhabung von EVA aufwändig ist, sind allerdings alternative Haftvermittler vorteilhaft. Besonders bevorzugt ist daher vorgesehen, dass der Haftvermittler ein Copolymer aus Monomereinheiten von Olefinen, Acrylaten und Maleinsäureanhydrid ist. Bevorzugt handelt es sich beim Olefin um Ethen und beim Acrylat um einen Alkylester der Acrylsäure (Alkylacrylat).

Besonders bevorzugt weist das Copolymer folgende Struktur auf 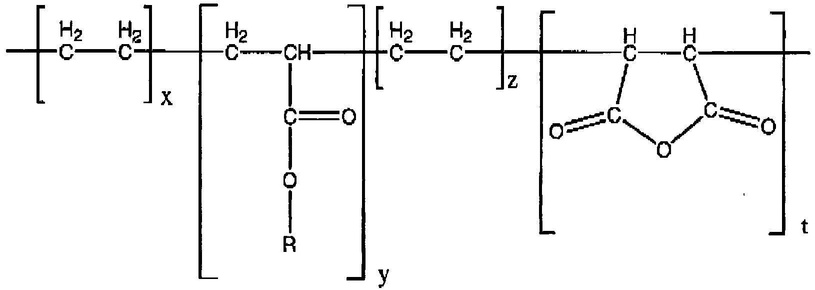 mit der Maßgabe, dass R = Methyl (-CH₃), Ethyl (-C₂H₅) oder Butyl (-C₄H₉) und x, y, z ganze Zahlen sind. Bevorzugt beträgt der Anteil (jeweils in Md-%) an Alkylacrylat (vorzugsweise Butylacrylat) zwischen 15 und 20%, an Maleinsäureanhydrid zwischen 3 und 4%, Rest Olefin. Das Copolymer weist bevorzugt eine Schmelzflussrate (MFR) bei 190° C gemessen nach ASTM D 1238 von 2 g/10 min bis 3 g/10 min auf. Das Copolymer weist bevorzugt eine Dichte bei 20° C von 0.85 bis 0.96 g/cm³ auf. Der Vicat-Erweichungspunkt nach ASTM D1525 liegt bevorzugt zwischen 62 und 74°C. Für eine gute Durchmischbarkeit liegt die Verarbeitungstemperatur des Copolymers bei 270°C. Im fertigen Zustand bildet der Haftvermittler mit den eingebetteten Solarzellen eine eigene Schicht im Coextrudatkörper. Die Dicke dieser Schicht beträgt dabei bevorzugt zwischen 50 µm und 400 µm.

Bei allen Thermoplasten handelt es sich, wie bereits eingangs erwähnt, um fluorfreie Thermoplasten. Hinsichtlich der Temperaturstabilität sind Polyester und Polyamide günstig. Besonders hohe Stabilität weisen allerdings Polyamide auf. Daher ist bevorzugt vorgesehen, dass wenigstens eine Thermoplastschicht eine Polyamidschicht ist, vorzugsweise Polyamid 11, Polyamid 12, Polyamid 1010 oder gegebenenfalls ein Blend dies Polyamide oder ein Polyamid/Polyolefin-Blend. Besonders bevorzugt sind alle Thermoplastschichten aus Polyamid ausgebildet. Wiederum sind Polyamid 11, Polyamid 12, Polyamid 1010 oder ähnliche Polamidtypen bevorzugt vorgesehen.

Der oben genannte Coextrudatkörper eignet sich natürlich auch, gesondert hergestellt zu werden und anschließend auf die Solarzelle aufgebracht zu werden. Daher betrifft die Erfindung in einem weiteren Aspekt einen Coextrudatkörper, umfassend eine erste Thermoplastschicht mit einem Füllstoff, der ein Reflexionsvermögen aufweist, das höher ist als das Reflexionsvermögen des Thermoplasten und einer zweiten Thermoplastschicht, die einen Füllstoff umfasst, der eine höhere Wärmeleitfähigkeit als der Thermoplast aufweist, wobei die Thermoplasten ausgewählt sind aus der Gruppe der Polyamide, Polyolefine, Polyester oder Blends aus Polyamiden und Polyolefinen wie (Polypropylen), wobei der zweite Füllstoff für die zweite Thermoplastschicht ausgewählt ist aus der Gruppe Wollastonit, Bornitrid oder Glasfasern sowie Mischungen daraus.

Die erste Thermoplastschicht kann zusätzlich zum Füllstoff, der das Reflexionsvermögen erhöht, auch noch den zweiten Füllstoff, der die Wärmeleitfähigkeit erhöht, bis zu einem Gehalt von 20 Gew.% enthalten.

Bevorzugte Schichtdicken liegen zwischen 25 µm und 50 µm für die erste Thermoplastschicht, zwischen 150 µm und 400 µm für die zweite Thermoplastschicht und 25 µm und 50 µm für die dritte Thermoplastschicht.

Die beschriebenen Coextrudatkörper finden selbstverständlich Einsatz in den zuvor genannten Solarmodulen. Insgesamt ist festzuhalten, dass das zu den Coextrudatkörpern und Solarmodulen wechselweise gleichermaßen gilt, d.h. vorteilhafte Ausführungen des einen sind gleichermaßen vorteilhafte Ausführungen des anderen.

Die Erfindung betrifft weiters die Verwendung von Coextrudatkörpern der oben genannten Art für die Herstellung von Solarmodulen.

Weitere Vorteile und Details werden anhand der nachfolgenden Figuren und Figurenbeschreibungen erläutert. Es zeigt jeweils grob schematisiert
- Fig.1: einen Querschnitt durch ein Solarmodul gemäß Stand der Technik
- Fig. 2: schematisch die Funktionsweise eines Solarmoduls,
- Fig. 3a, 3b: zwei Ausführungsvarianten an Solarmodulen und
- Fig. 4a, 4b: Ausführungsvarianten des Coextrudatkörpers.

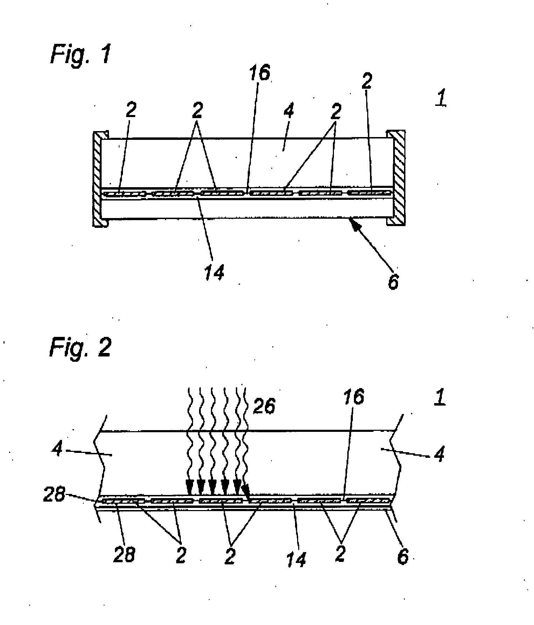

In der Fig. 1 ist schematisch ein Solarmodul 1 nach Stand der Technik abgebildet. Dabei sind mehrere elektrisch leitend miteinander verbundene Solarzellen 2 vorgesehen, die zwischen einer Frontabdeckung 4 und einer Rückabdeckung 6 angeordnet sind. Die Frontabdeckung 4 ist aus Glas oder gegebenenfalls transparentem Kunststoff ausgebildet. Die Solarzellen 2 sind in einem Einbettungsmaterial 14, 16 eingebettet. Das Einbettungsmaterial 14, 16 dient gleichzeitig als Haftvermittlerschicht 14, 16 und besteht aus EVA. EVA stellt eine Verbindung zwischen Frontabdeckung 4 und Solarzellen 2 (dargestellt als Haftvermittlerschicht 16) her, während das EVA ebenfalls eine Verbindung zwischen Rückabdeckung 6 und Solarzelle 2 her (dargestellt als Haftvermittlerschicht 14). Die Rückabdeckung 6 ist aus einem Fluorpolymer ausgebildet. In der Regel handelt es sich dabei um PVF oder gegebenenfalls auch Polyvinylidenfluorid PVDF. Derartige Fluormaterialien sind sehr temperaturstabil, weisen allerdings den Nachteil auf, dass sie nur sehr aufwändig recycelt werden können. Zusätzlich weist das Solarmodul eine Rahmen 24 auf, der die Befestigung an einem Dach oder einer Fassade erleichtert.

Die Funktionsweise von Solarmodulen allgemein wird anhand der Fig. 2 erläutert. Die Solarzellen 2, genauer gesagt die photovoltaischen Zellen, sind elektrische Bauelemente, die kurzweilige Strahlungsenergie, also beispielsweise Sonnenlicht, direkt in elektrische Energie wandeln. Die physikalische Grundlage dieser Umwandlung ist der photovoltaische Effekt, der ein Sonderfall des inneren photoelektrischen Effekts darstellt. Meist umfassen die Solarzellen 2 Halbleiter, insbesondere auf Siliziumbasis.

Einfallendes Licht 26 trifft auf die Frontabdeckung 4 auf, die Lichtdurchlässig ist, d.h. einen großen Teil des für die Solarzelle günstigen Lichtspektrums, vorzugsweise über 90% Transmission, durchlässt. Durch den photovoltaischen Effekt wird die elektromagnetische Strahlung in elektrische Energie umgewandelt. Die einzelnen Solarzellen 2 sind elektrisch leitend miteinander Verbunden und über Anschlüsse 28 (nur grob schematisch dargestellt) kann die erzeugte elektrische Spannung abgegriffen werden.

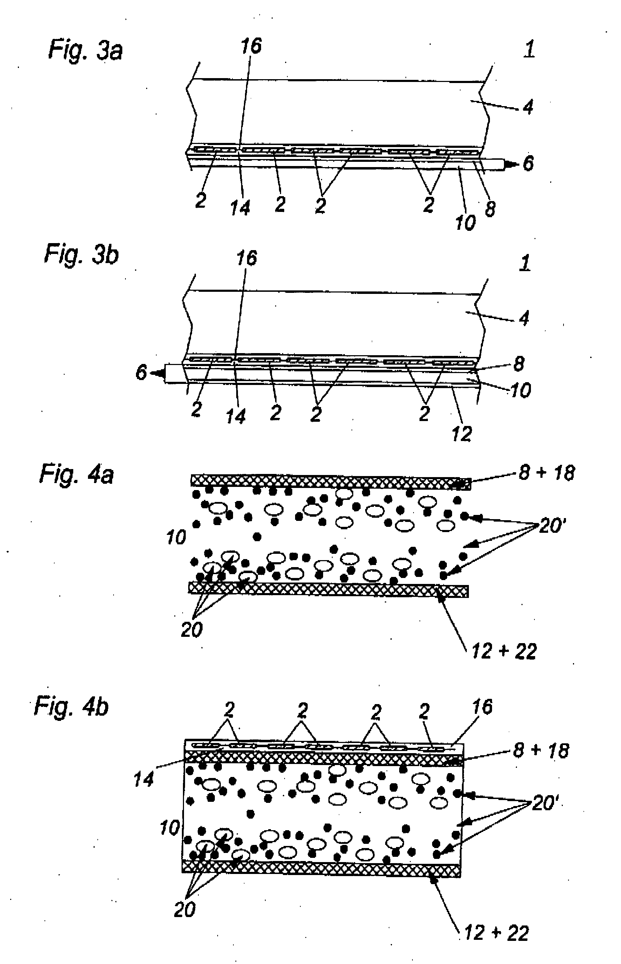

In der Fig. 3a ist eine erste Ausführungsvariante gezeigt. Dabei wird ein Solarmodul 1 ebenfalls aus Solarzellen 2 gebildet, die von einer Frontabdeckung 4 und einer Rückabdeckung 6 umgeben ist. Die Solarzelle 2 ist in einem Haftvermittler 14, 16 (allseitig) eingebettet - dies um ein Brechen der Zellen zu verhindern und Kurzschlüsse zu vermeiden. Die Frontabdeckung 4 kann dabei beispielsweise aus Glas oder transparentem Kunststoff ausgebildet sein. Der Haftvermittler 14,16 stellt eine Verbindung zwischen Frontabdeckung 4 und Solarzellen 2 sowie zwischen Rückabdeckung 6 und Solarzellen 2 her. Die Rückabdeckung 6 ist im gezeigten Ausführungsbeispiel als zweischichtiges Coextrudat 6' ausgebildet, d.h. sie umfasst eine erste Thermoplastschicht 8 aus Polyamid 11, Polyamid 12 oder Polyamid 1010 und eine zweite Thermoplastschicht 10 ebenfalls aus Polyamid 11, Polyamid 12 oder Polyamid 1010. Vorzugsweise nur die erste Thermoplastschicht 8 weist dabei einen Füllstoff 18 auf, der das Reflexionsvermögen dieser Schicht erhöht. Konkret wird Titandioxid als erster Füllstoff 18 eingesetzt, der praktisch das gesamte auf diese Schicht noch auftreffende Licht an die Solarzelle 2 zurück reflektiert, wodurch die Lichtausbeute insgesamt erhöht wird. Vorzugsweise nur die zweite Thermoplastschicht 10 weist einen zweiten Füllstoff 20 auf, der eine höhere Wärmeleitfähigkeit als der Thermoplast aufweist. Dadurch wird die Wärme besser abgeführt und die Langzeittemperaturbeständigkeit erhöht. Konkret wird als zweiter Füllstoff Eisenglimmer verwendet, der aufgrund seines Schichtaufbaus und seiner Ausbildung als elektrischer Isolator den Durchschlagswiderstand erhöht. Auf der Unterseite der zweiten Schicht 2 könnte beispielsweise noch eine Mattierungsschicht aufgebracht sein. Die Füllstoffe sind aus Gründen der besseren Darstellbarkeit nur in der Fig. 4 genauer dargestellt.

Das Ausführungsbeispiel der Fig. 3b zeigt eine Variante mit einer dreischichtigen Rückabdeckung 6 die gleichzeitig den Coextrudatkörper 6' bildet. Da der übrige Aufbau dem Beispiel der Fig. 3a entspricht, wird auf die bereits im Rahmen der Figurenbeschreibung zu Fig. 3a erläuterte Beschreibung zurückgegriffen und der entsprechende Aufbau nicht mehr erläutert. Die zusätzlich vorgesehene dritte Thermoplastschicht 22 ist im bevorzugten Fall ebenfalls aus Polyamid ausgebildet und weist ein Mattierungsmittel auf, damit die Reflexion an der Rückseite verringert ist. Dies erhöht den Komfort bei der Montage des Solarmoduls 1, da so der Monteur weniger geblendet wird. Bei einem solchen Schichtaufbau dient die Schicht 8 als Reflexionsschicht mit hochglänzender Oberfläche, die Schicht 10 weist die höhere Wärmeleitfähigkeit auf, um einen Wärmestau bzw. eine Überhitzung zu vermeiden, die Schicht 12 ist witterungsbeständig und UV-stabil z.B. durch Zugabe von UV-Stabilisatoren.

Die Fig. 4a und 4b zeigen erfindungsgemäße Coextrudatkörper 6' in Anlehnung an das Beispiel der Fig. 3b. Die gezeigten Schichten entsprechen daher denen der Fig. 3b, sodass auf die obige Beschreibung verwiesen werden kann. Bei diesem Schichtaufbau handelt es sich um das bevorzugte Ausführungsbeispiel. Angedeutet ist der erste Füllstoff 18 in der ersten Thermoplastschicht 8 aus Polyamid durch Punktierung. Der zweite Füllstoff 20, 20' in der zweiten Thermoplastschicht 10, ebenfalls aus Polyamid, liegt dabei einerseits als Compound vor und ist in einen Polyolefinträger aus PE eingebettet. Andererseits ist ein weiterer Füllstoff 20' vorhanden, der in Reinform eingebracht ist. Füllstoff 20 ist z.B. ein PP-Compound mit Glas und/oder Eisenglimmer, Füllstoff 20' vorzugsweise Muskovit und/oder Wolastonit. Der PP-Compound verbessert die Wärmeleitfähigkeit durch die Glasfaser oder den Eisenglimmer. In der dritten Thermoplastschicht 12 ist ein Mattierungsmittel 22 enthalten. Erste, zweite und dritte Thermoplastschicht 8, 10, 12 liegen als Coextrudatkörper 6' vor. Der Unterschied zwischen der Fig. 4a und der Fig. 4b besteht darin, dass die Fig. 4b zusätzlich eine Haftvermittlerschicht 14,16 aufweist, in die vorzugsweise Solarzellen 2 eingebettet sind. Die Haftvermittlerschicht 14, 16 besteht aus einem Ethylen-Acrylester-Maleinsäureanhydrid Polymer mit einem MFR vom 2.6 g/10 min nach ASTM D1238 und einer Dichte von 0.89 g/cm³ bei 20 °C. Die Haftvermittlerschicht 14,16 ist in den gezeigten Ausführungsbeispielen mit zwei Bezugszeichen 14, 16 versehen worden, um die Figuren übersichtlicher zu gestalten. Tatsächlich handelt es sich in der Praxis vorteilhafterweise um nur eine Schicht in die die Solarzellen 2 eingebettet werden, wobei Rückabdeckung 6 und Frontabdeckung 4 gleichzeitig mit dieser Haftvermittlerschicht aufweisend die Solarzellen 2 verbunden wird.

Ein wesentlicher Unterschied zum Stand der Technik liegt in den sehr unterschiedlichen Thermoplastschichten 8 und 10. Die Thermoplastschicht 8 besteht aus dem Trägermaterial Polyamid 12, 11 oder 1010, ist sehr hoch stabilisiert gegen UV-Strahlen, aber vor allem sehr hoch gefüllt mit TiO₂ (mindestens 20 bis 30 %). Dies ergibt mit speziell behandeltem TiO₂ eine hohe UV-Beständigkeit, aber vor allem eine sehr hohe Reflexion von ca. 95 % (Ein Prozentsatz, der wesentlich höher liegt als alle bisher bekannten Folien.). Diese hohe Reflexion ergibt eine messbare Steigerung des Wirkungsgrades, da das Sonnenlicht durch die Schichten 4, das Einbettungsmaterial 14 bzw. 16 sowie die immer dünner ausgebildeten Solarzellen 2 (Dicke derzeit zwischen 100 und 180 µm) durchscheint und von der Thermoplastschicht 8 reflektiert wird.

Die zweite Thermoplastschicht 10 ist wesentlich anders zusammengesetzt. Dieser Schicht kommt vor allem die Aufgabe zu durch Füllstoffe wie Glasfasern den Längenausdehnungskoeffizenten zu verringern. Zum Beispiel wird dieser bei PA 12 von 120 bis 140 (10 hoch minus 6/K) um längs bis zu 70 % und quer bis zu 30 % reduziert. Dies ist notwendig um sich den Werten der Glasplatte 4 anzunähern. Glas hat bekanntlich wesentlich niedrigere Ausdehnungskoeffizienten im Vergleich zu Thermoplasten. Materialien mit geringen Schwindungen verhindern ein Ablösen der Backsheetfolie, die über das Einbettungsmaterial 14 bzw. 16 mit der Glasplatte 4 verklebt sind.

Eine sehr wichtige Funktion kommt den Füllstoffen, speziell Glas, zu. In hoher Konzentration (20 bis 30 %) wird die Langzeittemperaturstabilität stark erhöht. Derzeit gemessener RTI (relativer Temperatur Index) liegt bei 130 Grad. Reines PA 12, 11 oder 1010 haben einen RTI-Wert von 85 bis 95 Grad, Weitere Füllstoffe können die erfindungsgemäß angeführte Durchschlagsfestigkeit bzw. Wärmeleitfähigkeit verbessern. Die Thermoplastschicht 10 ist eine Legierung aus Polyamiden (höherer Anteil) und Polyolefinen, die vornehmlich den Füllstoffgehalt beinhalten. Diese Legierung zeigt eine verbesserte Wasserdampfsperre auf und eine reduzierte Wasseraufnahme im Vergleich zu Polyamiden. Geringere Wasserdampfdurchlässigkeit lässt höhere Stromspannungen im Gesamtmodul zu.

Wichtig ist bei beiden Schichten, dass relativ hohe Füllstoffkonzentrationen vorhanden sind, um die in den Ansprüchen festgehaltenen Werte merklich zu erhöhen. Daher ist es sehr vorteilhaft mindestens zwei bzw. drei Schichten zusammen zu extrudieren, um die geforderten und angeführten Eigenschaften zu erhalten. Geringe Füllstoffmengen (unter 5 Gew. %) führen zu kaum messbaren Veränderungen in der Material-eigenschaft. In einer Schicht sind die geforderten Eigenschaften, die sehr unterschiedlich wirken, nicht umzusetzen, da der Füllstoffgehalt bzw. die Thermoplastlegierung nur als unterschiedliche Extrudate, vorzugsweise auf mehreren Extrudern, koextrudiert werden können.

## Patentansprüche

1. Coextrudatkörper (6'), umfassend eine erste Thermoplastschicht (8) mit einem ersten Füllstoff (18), der ein Reflexionsvermögen aufweist, das höher ist als das Reflexionsvermögen des Thermoplasten der ersten Thermoplastschicht (8) und einer zweiten Thermoplastschicht (10), die einen Füllstoff (20) umfasst, der eine höhere Wärmeleitfähigkeit als der Thermoplast der zweiten Thermoplastschicht (10) aufweist, wobei in den beiden Thermoplastschichten (8, 10) der jeweilige Anteil des ersten (18) oder zweiten (20) Füllstoffes vom Anteil des selben Füllstoffes (18, 20) in der jeweils anderen Thermoplastschicht (10, 8) verschieden ist und wobei zumindest eine Thermoplastschicht eine Polyamidschicht ist.

2. Coextrudatkörper nach Anspruch 1, **dadurch gekennzeichnet, dass** eine dritte Thermoplastschicht (12) vorgesehen ist, die auf der zweiten Thermoplastschicht (10) angeordnet ist.

3. Coextrudatkörper nach Anspruch 2, **dadurch gekennzeichnet, dass** die dritte Thermoplastschicht (12) ebenfalls coextrudiert und zusätzlich eingefärbt ist und/oder Mattierungsmittel und/oder einen UV-Stabilisator aufweist.

4. Coextrudatkörper nach einem der Ansprüche 1 bis 3, **dadurch gekennzeichnet, dass** der erste Füllstoff (18) Titandioxid umfasst.

5. Coextrudatkörper nach einem der Ansprüche 1 bis 4, **dadurch gekennzeichnet, dass** Füllstoffe (18, 20) flächig oder fasrig ausgebildet sind.

6. Coextrudatkörper nach einem der Ansprüche 1 bis 5, **dadurch gekennzeichnet, dass** der zweite Füllstoff (20) ausgewählt ist aus der Gruppe Muskovit, Wollastonit, Bornitrid, Eisenglimmer, Glasfasern eingebettet in Polyolefin, oder Mischungen daraus.

7. Coextrudatkörper nach einem der Ansprüche 1 bis 6, **dadurch gekennzeichnet, dass** auf der ersten Thermoplastschicht (8) ein Haftvermittler angeordnet ist.

8. Coextrudatkörper nach Anspruch 7, **dadurch gekennzeichnet, dass** der Haftvermittler ein Copolymer aus den Monomereinheiten Olefin, vorzugsweise Ethen, Acrylat, vorzugsweise Alkylacrylat und Maleinsäureanhydrid ist.

9. Coextrudatkörper nach einem der Ansprüche 1 bis 8, **dadurch gekennzeichnet, dass** die Thermoplasten ausgewählt sind aus der Gruppe der Polyamide, Polyester oder Blends aus Polyamiden und Polyolefinen.

10. Solarmodul mit wenigstens einer Solarzelle (2), die zwischen einer Frontabdeckung (4) und einer Rückabdeckung (6) angeordnet ist, wobei die Frontabdeckung (4) den Durchtritt von Licht zur Solarzelle (2) ermöglicht, mit einer Rückabdeckung (6), die einen wenigstens zweischichtigen, halogenfreien Coextrudatkörper (6') nach einem der Ansprüche 1 bis 9 umfasst.

11. Fassadenelement umfassend ein Solarmodul nach Anspruch 10.
